# EUROPEAN PATENT APPLICATION

(11) **EP 1 734 584 A1**
(43) Date of publication of application: **20.12.2006**
(21) Application number: 05076388.7
(22) Date of filing: 14.06.2005
(51) Int. Cl.: H01L 27/146, H01J 31/49

(54) **Electron bombarded image sensor array device as well as such an image sensor array**

(71) Applicant: Photonis-DEP B.V., 9301 ZR Roden (NL)
(72) Inventor: Tomuta, Daniela Georgeta, 9728 VJ Groningen (NL); Meinen, Albert Hendrik Jan, 9734 BV Groningen (NL); Ruiter, Gezinus, 9301 XM Roden (NL); van Spijker, Jan, 9301 TH Roden (NL)
(74) Representative: Valkonet, Rutger

(57) **Abstract**

The invention relates to an electron bombarded image sensor array device comprising a vacuum chamber having a photocathode capable of releasing electrons into said vacuum chamber when exposed to electromagnetic radiation impinging on said photocathode, electric field means for accelerating said released electrons from said photocathode towards an anode spaced apart from said photocathode in a facing relationship to receive an electron image from said photocathode, said anode being constructed as an back thinned image sensor array having electric connecting pads and being mounted to a carrier using mounting means, said carrier having electric connecting pads to feed electric signals from said image sensor array finally outside said vacuum chamber.

The invention also relates to an image sensor array to be used in such a device.

## Description

The invention relates to an electron bombarded image sensor array device comprising a vacuum chamber having a photocathode capable of releasing electrons into said vacuum chamber when exposed to electromagnetic radiation impinging on said photocathode, electric field means for accelerating said released electrons from said photocathode towards an anode spaced apart from said photocathode in a facing relationship to receive an electron image from said photocathode, said anode being constructed as an back thinned image sensor array having electric connecting pads and being mounted to a carrier using mounting means, said carrier having electric connecting pads to feed electric signals from said image sensor array finally outside said vacuum chamber.

The invention also relates to an image sensor array to be used in such a device.

Integrated circuit devices (IC) are typically fabricated from semiconductor or more specific silicon dies (CCD's, CMOS's or HPD's) and often used as image detectors. Mounting such dies in vacuum modules can include supporting carriers or substrates and headers. Typically the support carriers or substrates are subsequently mounted to a header or a ultra high vacuum ceramic carrier (UHV header), which includes pins or other leads to allow the entire device to be electrically connected to the final camera system.

In certain circumstances, the image sensor array (ISA) dies are back thinned to allow back illumination (UV application) or electron back bombardment.

An device according to the above preamble is for example known from the United States Patent No. 6,020,646. In this US Patent the IC die is mounted to the carrier via a thin layer of glass powder or frit. The carrier facilitates a fixture and, together with the sintered glass powder (frit), can provide support during the subsequent further manufacturing process steps, such a thinning etc. as well during operating the electron bombarded image sensor array. The thin support layer of glass frit is free of out-gassing in ultra high vacuum environments. The frit glass must have the thermal expansion behaviour close to that of Silicon and when fired below the maximum allowed temperature of the image sensor array, the glass is sintered near its full density offering a compact mechanical support between the carrier and the IC die.

An image sensor array device having a construction as disclosed in US Patent No. 6,020,646 exhibits a rather complicated construction and requires specific manufacturing techniques as well as intermediate steps e.g. lapping the frit to reduce its thickness and to achieve the ball metallic contacts, prior to mounting on the carrier and (even) thinning the sensor.

A further drawback resides in the fact that the construction of such electron bombarded devices as disclosed in US Patent No. 6,020,646 (mounted to a carrier) is performed always on the IC die level with many intermediate processing steps. This method is rather inefficient for production on a large scale.

The present invention obviates the above identified drawbacks and provides an image sensor array device having a less complicated construction and which requires less complicated manufacturing steps. According to the invention said mounting means consist of electrically conducting connecting support elements, electrically connecting at least one of said electric connecting pads of said image sensor array with at least one of said electric connecting pads of said carrier.

Surprisingly, it has been found that a sufficient reliable and functioning construction of an electron bombarded image sensor array device can be obtained by only using the electrical connecting means, which are primarily used for electrically connecting the image sensor array with the carrier, also as sole mounting means. Additional mounting features are herewith obviated, as well as the associated corresponding manufacturing steps thus resulting in an far less complicated construction with fewer components and possibly reduced dimensions.

It is further the aim of the invention to provide another mounting method, whereby the back thinning process is carried out on wafer scale followed by dicing and prior to the mounting of individual sensor array dies to corresponding individual carriers.

For obtaining an additional improved and stable mounting of the back-thinned image sensor array on the carrier said mounting means further comprise additional support elements being positioned between the front side of said image sensor array and said carrier in a non-electric connecting manner.

In a preferred embodiment said mounting means exhibit a three-dimensional shape having at least one dimension in lateral direction parallel to the plane of the image sensor array and/or the carrier, said lateral dimension being larger than its dimension in a direction perpendicular to the plane of the image sensor array and/or the carrier.

More in particular said lateral dimension is at least one order of magnitude larger than said perpendicular dimension. Furthermore said mounting means may have a bump shape and more in particular, the mounting means constructed as contact bumps have a height of at the most 10 micron.

Preferably, said mounting means (contact bumps) are made of high purity Au, In, Sn, Pb or alloys with melting points below the maximum allowable temperature dictated by the limitations of the image sensor array.

According to another embodiment of the invention the image sensor array is positioned in such manner, that the back side of the sensors is in a facing relationship with the photocathode and more in particular the back side of the sensor is fully back thinned prior to the mounting to the carrier.

The invention will now be described more clearly in the following figurative description using the accompanying drawings, which show in:
Figure 1 an embodiment of an image sensor array device according to the state of the art;
Figure 2 a first embodiment of a sensor/detector array according to the invention.

It is emphasized that according to common practice, the various features of the drawings are not drawn to scale. Like reference numerals are used to represent like elements among the figures.

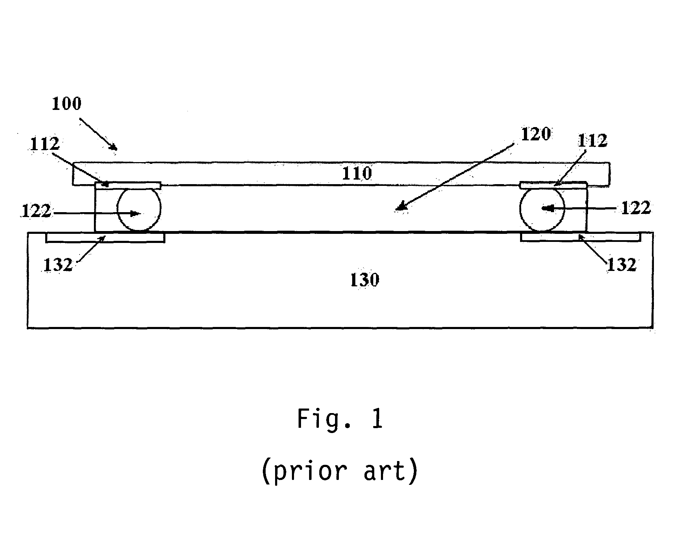

Figure 1 discloses one of the possible embodiments for an EBCCD circuit device according to the state of the art and as disclosed in the above identified US Patent No. 6,020,646. In the device 100 according to the state of the art reference number 110 denotes a thinned CCD array die, the front side of 110 CCD being mechanically attached to a carrier 130 by a mounting material 120 and ball bonds 122. The mounting material 120 is preferably a layer of glass frit with a predefined thickness. The conductive pads 112 of the same front side CCD 110 are electrically connected to the ball bonds 122, which further complete the electrical connection with the conductive pads 132 from the carrier 130.

The central idea of the above patent is about using frit glass and embedded metallic ball bonds as mounting means. After sintering the frit glass layer 120 and lapping it in order to reach the ball bonds 122, the IC die 110 is first pressed onto the carrier 130 and further back-thinned, thus fully processed.

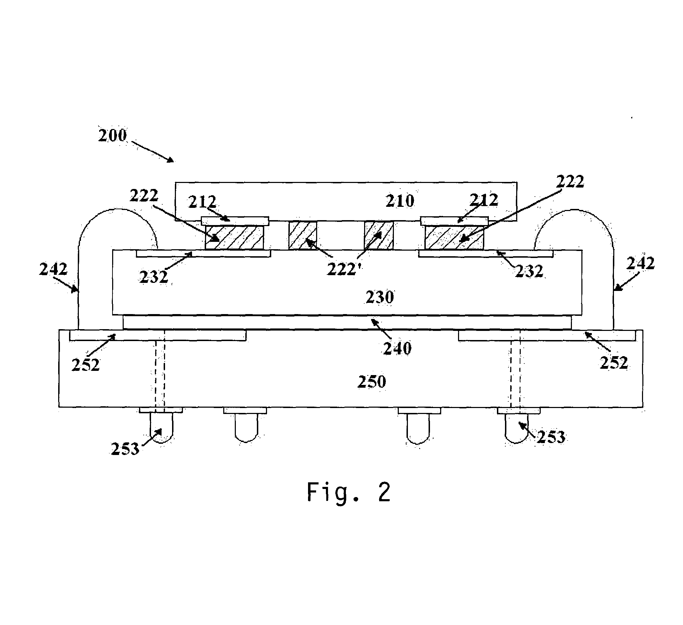

Figure 2 shows a diagrammatic view of an image sensor array (ISA) device 200 in accordance with the present invention. In the preferred embodiment, the image sensor array (ISA) die 210 is on first instance thinned to a thickness of 10-20 microns on wafer scale prior to the mounting in the present embodiment. The total assembly 200 includes a fully back thinned image sensor array (ISA) die 210, the front side (hence the side facing the carrier 230) of which is mechanically attached to a carrier 230, via electrical 222 and non-electrical connection means 222'.

Said connection means 222 and 222' are constructed as so-called contact bumps. In this description, the term "bump" is defining the electrically conductive connecting supports placed between the carrier and the front side of an image sensor array back-thinned die.

The front side of the thinned image sensor array die 210 includes connecting pads 212, normally used for wire-bonding. The carrier 230 also includes conductive pads 232 congruent to or overlapping the conductive pads 212 of the image sensor array (ISA) die 210. The image sensor array (ISA) die 210 is mounted to the carrier 230 only using mounting means, constructed as contact bumps 222.

Hereinafter, the term "bump" is defining the electrically conductive connecting supports placed between the carrier 230 and the front side of an image sensor array back-thinned die 210. The bumps 222 are electrically connecting at least one of said electric connecting pads 212 of said image sensor array 210 with at least one of said the electric connecting pads 232 of said the carrier.

The mounting means 222 exhibit a three-dimensional shape having at least one dimension in lateral direction parallel to the plane of the image sensor array 210 and/or the carrier 230, said lateral dimension being larger than a dimension in a direction perpendicular to the plane of the image sensor array 210 and/or the carrier 230.

More in particular said lateral dimension is at least one order of magnitude larger than its perpendicular dimension. Preferably the height (the perpendicular dimension) of the mounting means 222 is at most 10 micron.

In the preferred embodiment, the image sensor array (ISA) die 210 can be for example an CMOS or CCD die, where the usual conductive bonding pads 212 have a dimension in the hundred of microns range. The electric contact pads 222 realised between the ISA die 210 and the carrier 230 have a maximum height of about 10 microns leaving only a small empty space between the ISA die 210 and its carrier 230. The same electric contact bumps 222 are also serving as mounting means to support the thinned ISA die 210.

In case of larger image sensor arrays for an even better mechanical support, additional contact bumps 222' can be used. The additional contact bumps 222' are positioned in between the image sensor array die 220 and the carrier 230, wherein the connection is established in a non-electric connecting manner, therefore having no electrical function.

Both mounting means, the electric contact bumps 222 and non-electric contact bumps 222' can be designed and constructed on the same time and using the same type of metallic material direct on the carrier 230, for example made from In or Au-Sn or alternatives having the right composition and having a similar construction and dimensions.

After designing and constructing the electric contact bumps 222 and where the case is, the non-electric contact bumps 222', the carrier 230 is further fixed on a ultra high vacuum (UHV) 250 carrier or header which includes leads or pins 253 finally outside the vacuum tube.

A glass layer 240, e.g FX11-036, or any other type of adhesive intermediate material withstanding the high vacuum requirements, is prepared to realise the fixation of the carrier 230 onto the UHV header 250. The glass layer or any other type of adhesive intermediate material used must keep its perfect adherence, sealing and uniformity properties more than one time above 400 °C.

The image sensor array die 210, handled with a vacuum chuck, is positioned and aligned on top of those contact bumps 222 and/or 222' such that all electric pads of the ISA die 212 have their final correspondent electric pad on the carrier 232 via the mounting means 222. The whole construction is heated to a maximum temperature dictated by the image sensor array characteristics (usually about 450 °C) such that the electric-metallic contact is fully established between all three dimensional components, namely the image sensor array contact pads 212, the (mounting means) contact bumps 222 and the contact pads of the carrier 232.

Finally, wire connections 242 are made between the carrier's extended contact pads 232 and the contact pads 252 of the UHV header 250.

The total device 200 is further high vacuum processed and closed under high vacuum requirements and specific temperatures.

The present embodiment offers a much simpler, less costly and stable solution for mounting a back-thinned ISA die into a vacuum tube.

## Claims

1. An electron bombarded image sensor array device comprising
a vacuum chamber having a photocathode capable of releasing electrons into said vacuum chamber when exposed to electromagnetic radiation impinging on said photocathode,
electric field means for accelerating said released electrons from said photocathode towards an anode spaced apart from said photocathode in a facing relationship to receive an electron image from said photocathode,
said anode being constructed as an back thinned image sensor array having electric connecting pads and being mounted to a carrier using mounting means,
said carrier having electric connecting pads to feed electric signals from said image sensor array outside said vacuum chamber, **characterized in that** said mounting means consist of electrically conducting support elements, electrically connecting at least one of said electric connecting pads of said image sensor array with at least one of said electric connecting pads of said carrier.

2. An electron bombarded image sensor array device according to claim 1, **characterized in that** said mounting means further comprise additional support elements being positioned between said image sensor array and said carrier in a non-electric connecting manner.

3. An electron bombarded image sensor array device according to claim 1 or 2, **characterized in that** said mounting means exhibit a three-dimensional shape having at least one dimension in lateral direction parallel to the plane of the image sensor array and/or the carrier, said lateral dimension being larger than its dimension in a direction perpendicular to the plane of the image sensor array and/or the carrier.

4. An electron bombarded image sensor array device according to claim 3, **characterized in that** said lateral dimension is at least one order of magnitude larger than said its perpendicular dimension/height.

5. An electron bombarded image sensor array device according to claim 3 or 4, **characterized in that** said perpendicular dimension is at most 10 micron.

6. An electron bombarded image sensor array device according to any one of the preceding claims, **characterized in that** said mounting means are made of high purity Au, In, Sn, Pb or alloys with melting points below the maximum allowable temperature dictated by the limitations of the image sensor array.

7. An electron bombarded image sensor array device according to any one of the preceding claims, **characterized in that** the image sensor array is positioned in such manner, that the back side of the sensors is in a facing relationship with the photocathode.

8. An electron bombarded image sensor array device according to any one of the preceding claims, **characterized in that** the back side of the sensor is fully back thinned prior to the mounting to the carrier.

9. An electron bombarded image sensor array device according to any one of the preceding claims, **characterized in that** said image sensor array is an active pixel sensor CMOS.

10. An electron bombarded image sensor array device according to any one of the preceding claims, **characterized in that** the conducting support elements solely includes metallic bumps.

11. A thinned image sensor array having electric connecting pads extending to a carrier having electric connecting pads, using mounting means according to one or more of the claims 1-10.
